# EUROPEAN PATENT APPLICATION

(11) **EP 4 679 952 A1**
(43) Date of publication of application: **14.01.2026**
(21) Application number: 23931970.0
(22) Date of filing: 04.04.2023
(51) Int. Cl.: H05K 7/20

(54) **COOLING SYSTEM AND COOLING METHOD FOR ELECTRONIC APPARATUS**

(71) Applicant: Zyrq Inc., Nagaoka-shi, Niigata 940-0061 (JP)
(72) Inventor: SAITO, Motoaki, Tokyo 106-0043 (JP)
(74) Representative: Goddar, Heinz J.
(86) International application number: PCT/JP2023/013985
(87) International publication number: WO 2024/209558

(57) **Abstract**

To provide a simple and efficient cooling system and cooling method with which the cooling performance of an electronic apparatus is improved. This cooling system includes a cooling intermediate composite body. The cooling intermediate composite body includes: a non-conductive bag for wrapping an electronic apparatus including a substrate and a heating element mounted on the substrate; a heat sink; and a bonding layer joining a rear surface of the heat sink and one surface of the non-conductive bag. The bonding layer is formed of a heterogeneous material bonding film. A first opening is formed in the heterogeneous material bonding film. The first opening provides a window for thermally connecting the rear surface of the heat sink to one surface of the heating element.

## Description

### BACKGROUND

The present invention relates to a cooling system and a cooling method for electronic apparatuses and more particularly to the cooling system and the cooling method of efficiently cooling the electronic apparatuses, such as a supercomputer, that is used for a data center, an artificial intelligence processing system, a quantum computing system, a cryptographic processing system, or a blockchain processing system, for example, and requires high performance, stable operation, or low power consumption operation and generates a large amount of heat.

One of the biggest challenges determining the performance limits of computer-related equipment in recent years is power consumption. The importance of research into thrifty power consumption, particularly in supercomputers, is already widely recognized. Speed performance per watt (Flops/W) is one index for evaluating supercomputers. Cooling is estimated to consume more than 30% of the total power consumed by a data center, generating a growing demand for power reduction through improved cooling efficiency.

Conventional cooling methods become incapable of cooling the data centers in the summer due to recent global warming and extreme heat caused by weather anomalies. There is an urgent need to improve the cooling capacity of existing systems.

The processing power of data centers and computer systems must be increased exponentially in terms of the rapid growth of artificial intelligence processing, the increasing need for encryption processing, the rapid increase in cryptocurrency mining as a key example of blockchain processing, and the development of the metaverse, which is broadly predicted to grow rapidly. There is a remarkably increasing demand for enhanced cooling capacity.

Conventionally, air-cooled and liquid-cooled types are used to cool supercomputers and data centers. The liquid-cooled type is generally considered to exhibit better cooling efficiency because it uses liquid whose heat transference is significantly better than air. For example, the "TSUBAME-KFC" supercomputer, developed by the Tokyo Institute of Technology, achieved 4.50G Flops/W using a synthetic oil immersion cooling system. It ranked first in the "Green 500 List" of supercomputers published in November 2013 and June 2014. However, the coolant uses synthetic oil, which is highly viscous and forms an oil film. It is difficult to completely remove the oil from an electronic apparatus taken out of an oil-immersion rack, making the electronic apparatus maintenance (specifically such as adjustment, inspection, repair, replacement, and expansion) extremely difficult. Furthermore, operational troubles are reported due to the synthetic oil used, which corrodes and damages a packing material, for example, included in electronic printed circuit boards or the cooling system in a short time or leaks the refrigerant.

As a solution, an immersion cooling system is proposed that utilizes a fluorocarbon-based coolant instead of synthetic oil or mineral oil, which causes the aforementioned problems. Specific examples include the use of fluorocarbon-based coolants such as hydrofluoroether (HFE) compounds known as 3M's "Novec 7100," " Novec 7200, " and "Novec 7300" (Novec is a trademark of 3M). (For example, Japanese Unexamined Patent Application Publication No. 2013-187251, and Japanese Translation of PCT International Application Publication No. JP-T-2012-527109).

Since 2014, the inventor has been developing a new immersion cooling system and related technologies to directly cool electronic apparatuses by circulating a hardly evaporable coolant, containing a perfluorinated compound as its primary component, inside the open space of a cooling tank. (For example, Japanese Patent No. 5853072).

However, PFAS (perfluoroalkyl substances and polyfluoroalkyl substances), including all of these fluorocarbon-based coolants, have long been known to have adverse effects on humans, crops, and the natural environment. In December 2022, the world's largest manufacturer announced that it would completely cease production by the end of 2025. In Europe, both the production and use of PFAS are expected to be banned by law within the next few years.

There is a need for a new immersion cooling method that is more affordable and can be used widely worldwide without the use of any harmful compounds such as PFAS as a refrigerant, and excels more highly in the cooling capacity compared to immersion cooling methods using PFAS as a refrigerant, for example.

There is a typical example of a cooling method that does not use harmful compounds such as PFAS as a refrigerant and can use ordinary water (tap water or industrial water) rather than pure water. Specifically, the method attaches a "water-cooled block," containing a running water path for water to flow, to the inside of a copper or aluminum block instead of using a heat sink that is attached directly to the top surface of the semiconductor of the CPU (central processing unit) as the main heat source in a computer apparatus. (For example, Japanese Unexamined Patent Application Publication No. 2016-119345).

Another cooling method that can utilize water is proposed. A semiconductor chip mounted on a printed circuit board is placed in a flexible bag. The bag is then immersed in a container filled with water as a coolant. The bag is then closely attached to the semiconductor device by shrinking and deforming the bag due to a pressure difference between the inside and outside of the bag when the bag is filled with water or the pressure inside the bag is reduced. (For example, Japanese Patent No. 2804640).

Still another cooling method using water is proposed: a natural water-cooled computer, which uses river, lake, seawater, or tap water as a cooling source to directly cool the computer. Specifically, this cooling method immerses a computer in water by coating the printed circuit board surface with parylene resin. (For example, Ikki Fujiwara, et al. "The First Step Towards Direct Natural Water-Cooled Computers." Information Processing Society of Japan, Technical Report, High Performance Computing (HPC), 2017-HPC-158(5), March 1, 2017. pp. 1-5. URL:http://research.nii.ac.jp/~koibuchi/pdf/ikki-sighpc158.pdf).

Yet another cooling method is proposed to completely coat the entire printed circuit board with an ultra-nanohydrophobic thin film coating using silicon compound nanoparticles, make an electronic apparatus excellent in waterproof and moisture-resistant properties, and immerse it in water. (For example, U.S. Patent No. 10717881).

### SUMMARY

The cooling system disclosed in Japanese Unexamined Patent Application Publication No. 2016-119345 uses water as a refrigerant, instead of using hazardous substances such as PFAS as a refrigerant, as described in Japanese Unexamined Patent Application Publication No. 2013-187251, Japanese Translation of PCT International Application Publication No. JP-T-2012-527109, and Patent No. 5853072. A running water path is provided in the water-cooled block attached to the surface of the semiconductor element mounted in the electronic apparatus. The cooling system first cools the water-cooled block, and then only the semiconductor element directly being in contact with the water-cooled block. No cooling is applied to other electronic components and printed circuit boards that do not directly come into contact with the water-cooled block, generate unignorable, if not significant, heat, and still require cooling. Additional cooling, such as air cooling, is required. Modern supercomputers or electronic apparatuses used in data centers require cooling for not only the central processing unit (CPU), but also many other components such as graphics processing units (GPUs), highspeed memory, chipsets, power-related components such as field-effect transistors (FETs), electrolytic capacitors, network units, bus switch units, and solid-state drives (SSDs). These components generate significantly different amounts of heat. It is difficult to satisfactorily cool them all by using air cooling, which is inferior to liquid cooling in terms of cooling capacity. The water-cooled block generally requires a large supply of cooling water. The water-cooled block itself is large and is not shaped into fins like a heat sink, obstructing the airflow path for air cooling. At least two piping paths are required to supply water to and return water from the water-cooled block. The piping paths to cool the water-cooled block also obstruct the airflow path for air cooling to no small extent, resulting in extremely low cooling efficiency for objects not directly cooled by the water-cooled block.

The cooling system disclosed in Ikki Fujiwara, et al. "The First Step Towards Direct Natural Water-Cooled Computers." Information Processing Society of Japan, Technical Report, High Performance Computing (HPC), 2017-HPC-158(5), March 1, 2017. pp. 1-5. URL:http://research.nii.ac.jp/~koibuchi/pdf/ikki-sighpc158.pdf, completely coats the whole of electronic components and printed circuit boards with an electrically non-conductive, water-impermeable parylene thin film coating. The electronic components and printed circuit boards coated with the parylene thin film coating are then entirely immersed in water or seawater. The apparatus is cooled using the low temperature of the water or seawater that comes into contact with the entire parylene thin film coating.

Similarly, the cooling system disclosed in U.S. Patent No. 10717881 completely coats the whole of electronic components and printed circuit boards with an ultra-nanohydrophobic thin film coating using electrically non-conductive, water-impermeable silicon compound nanoparticles. The electronic components and printed circuit boards coated with the ultra-nanohydrophobic thin film coating are then entirely immersed in water. The apparatus is cooled using the low temperature of the water that comes into contact with the entire hydrophobic thin film coating.

In both the cooling systems described in "The First Step Towards Direct Natural Water-Cooled Computers" and U.S. Patent No. 10717881, the electronic components and printed circuit boards to be cooled are all in contact with water or seawater as a coolant, via the parylene thin film or hydrophobic thin film coating. When a CPU, as a major heat source, needs to be cooled efficiently, cooling capacity and efficiency are inevitably inferior to a cooling system that uses a coolant such as water to directly cool the heat sink by directly contacting the surface of a semiconductor, such as a water-cooled block, for example.

According to the above-described thin-film coating method, even a slight leakage from the coating can cause water to enter the coated electronic components and printed circuit boards. When power is applied, all the electronic components and printed circuit boards are short-circuited and irreversibly damaged. Complete coating is essential. However, other than visual inspection, the only way to determine an occurrence of short-circuiting is to apply power to the electronic apparatus. There is always a risk of losing objects when they are cooled. The problem of coating leakage is not limited to the time when the electronic apparatus is first used. Also, after the electronic apparatus is used, thin film coating may be subsequently damaged due to deterioration or aging, or even slight contact with other electronic apparatuses, inspection apparatuses, or tools during maintenance and inspection. There poses a dilemma. The parylene or hydrophobic thin film coating needs to be as thin as possible to increase thermal conductivity from the refrigerant for cooling. Contrastingly, the thin film coating must be thick enough to prevent leakage and breakdown, and damage to the electronic apparatus.

Recent electronic printed circuit boards and their shapes are increasingly complex three-dimensionally and continue to become reduced in size. Considerable technical challenges are expected to establish a technology that completely coats these components with a defect-free, perfect thin film. Cooling systems using these thin film coatings remain almost unpopular.

These thin films need to be coated strongly through the use of vapor deposition, for example. Electronic components or printed circuit boards whose surfaces are reformed are no longer covered by the quality assurance. Their use is at your own risk. It is extremely difficult to find demand for the coated electronic components after use. Basically, there is no hope of reusing or reselling them.

The water-cooling method disclosed in Japanese Patent No. 2804640 cools a semiconductor device by placing it in a flexible bag and immersing it in a coolant such as water. However, like thin-film coatings, bags prevent direct contact between the semiconductor device surface and the coolant, thereby limiting cooling performance.

As above, immersion cooling using PFAS, as a conventional liquid cooling method, will become unusable shortly. Without the use of PFAS, the use of non-conductive liquids, such as synthetic oils and silicones, results in insufficient cooling capacity. The immersion cooling system using water, having high cooling capacity, requires ensuring non-conductivity by thoroughly coating with a thin film to prevent leakage. However, a perfect coating is becoming increasingly difficult and remains unpopular with the progress of 3D printed circuit board structures and the miniaturization of electronic components.

The conventional liquid cooling method using a water-cooled block can achieve high cooling performance for the CPU as the main heat source. However, the large, water-cooled block and the piping path for water cooling prevent sufficient cooling for the many other electronic components and printed circuit boards that are cooled by air cooling.

There is also a problem with the conventional liquid cooling method of placing a semiconductor device in a flexible bag and immersing it in water for cooling. The bag prevents direct contact between the semiconductor device surface and the refrigerant, thereby limiting cooling performance.

Accordingly, an object of the present invention is to provide a simple, efficient, and inexpensive cooling system and method that solves the above-described problems of the prior art, improves the cooling performance of electronic apparatuses, and excels in maintainability.

To solve the above problems, one aspect of the present invention provides a cooling system in which the electronic apparatus is immersed in ordinary water (such as tap water, industrial water, or seawater), representing a typical example of electrically conductive and highly thermally conductive coolant, and the water directly cools a heat sink, which is often made of copper or aluminum and is thermally connected to electronic components including a CPU, as the main heat source. The cooling system according to a preferred embodiment of the invention includes a cooling intermediate composite body. The cooling intermediate composite body includes a non-conductive bag for encasing the electronic apparatus that includes a printed circuit board and at least one heat-generating element mounted on the printed circuit board; a heat sink; and a bonding layer for connecting the back surface of the heat sink and one surface of the non-conductive bag; The bonding layer is formed of a heterogeneous-material bonding film. A first opening is formed in the heterogeneous-material bonding film. The first opening provides a window for thermally connecting the back surface of the heat sink with one side of at least the single heat-generating element.

In a preferred embodiment of the cooling system, the bonding layer may make a watertight connection between the back surface of the heat sink and the exterior of the non-conductive bag.

In a preferred embodiment of the cooling system, a second opening is formed in the non-conductive bag. The first opening and the second opening may provide a window for thermally connecting the back surface of the heat sink with one surface of at least the single heat-generating element.

In a preferred embodiment of the cooling system, an elevated portion may be formed on the back surface of the heat sink. A second opening may be formed in the non-conductive bag. The first opening and the second opening may provide a window for thermally connecting an elevated surface of the elevated portion on the back surface of the heat sink with one surface of at least the single heat-generating element.

In a preferred embodiment of the cooling system, the non-conductive bag may form therein a third opening whose opening area is larger than a back surface area of the heat sink. The bonding layer may make a watertight connection between a back surface of the heat sink placed in the third opening and an interior of the non-conductive bag.

In a preferred embodiment of the cooling system, an elevated portion may be formed on a back surface of the heat sink. The non-conductive bag may form a third opening whose opening area is larger than an area of the elevated surface on the back surface of the heat sink. The bonding layer may make a watertight connection between a back surface, excluding the elevated surface, of the heat sink placed in the third opening and the interior of the non-conductive bag.

In a preferred embodiment of the cooling system, the heat sink may include a printed circuit board (PCB) fixing mechanism. The printed circuit board of the electronic apparatus may be fastened to the PCB fixing mechanism of the heat sink.

In a preferred embodiment of the cooling system, the PCB fixing mechanism of the heat sink may provide two or more threaded holes mutually separately formed on the back surface of the heat sink.

In a preferred embodiment of the cooling system, the cooling intermediate composite body may be configured so that an interior of the non-conductive bag closely contacts both sides of the printed circuit board and the surfaces of various electronic components mounted on the printed circuit board when the non-conductive bag is vacuumized inside.

In a preferred embodiment of the cooling system, the non-conductive bag may be configured to include a check valve that can provide a path for vacuumization and maintain hermeticity.

In a preferred embodiment of the cooling system, the non-conductive bag may include a zipper mechanism. The zipper mechanism may be configured so that an opened-zipper state permits placement of the electronic apparatus in the non-conductive bag, while a closed-zipper state maintains hermeticity of the non-conductive bag.

In a preferred embodiment of the cooling system, the non-conductive bag may include a heat-sealing mechanism. The heat-sealing mechanism may be configured so that an inactive heat-sealing state permits placement of the electronic apparatus in the non-conductive bag and vacuumization after heat sealing, while an active heat-sealing state maintains hermeticity of the non-conductive bag.

In a preferred embodiment of the cooling system, the non-conductive bag may form a penetration portion for passing a power cable, a network communication cable, or a control cable connected to an electronic apparatus. The sealing material provided for the penetration portion may be configured to maintain hermeticity of the non-conductive bag.

In a preferred embodiment of the cooling system, the cooling intermediate composite body may further include, in the non-conductive bag, a wireless power supply unit for supplying power to the electronic apparatus and a wireless communication unit for enabling wireless communication between the electronic apparatus and the outside.

In a preferred embodiment of the cooling system, the cooling system may further include, in the non-conductive bag, a monitor unit for monitoring the degree of vacuum in the non-conductive bag.

The cooling system according to a preferred embodiment may further include a controller that provides control to activate an external vacuum pump and vacuumize the non-conductive bag inside when output from the monitor unit indicates a vacuum level below a predetermined threshold.

The cooling system according to a preferred embodiment may further include a shutdown unit that stops operation of the electronic apparatus and turns off power when output from the monitor unit indicates a vacuum level below a predetermined threshold.

Additionally, another aspect of the present invention provides a cooling method for electronic apparatuses. The method includes the steps of preparing a cooling intermediate composite body by bonding a heat sink and a non-conductive bag together using a heterogeneous-material bonding film so that the heat sink surface is located outside the non-conductive bag; placing the electronic apparatus in the cooling intermediate composite body and making surface contact with and thermally connecting one surface of at least one heat-generating element, included in the electronic apparatus, with a back surface of the heat sink through a window formed in the heterogeneous-material bonding film; sealing the non-conductive bag; and immersing the sealed cooling intermediate composite body in a refrigerant.

In a preferred embodiment of the cooling method, the step of sealing the non-conductive bag includes a step of vacuumizing the non-conductive bag inside.

The cooling system according to the present invention uses the cooling intermediate composite body including: the non-conductive bag for encasing an electronic apparatus including the printed circuit board and at least one heat-generating element mounted on the printed circuit board; a heat sink; and a bonding layer to make a watertight connection between a back surface of the heat sink and one surface of the non-conductive bag, the bonding layer being formed of a heterogeneous-material bonding film. A first opening is formed in the heterogeneous-material bonding film. When an electronic apparatus is placed in the cooling intermediate composite body, the first opening provides a window for thermally connecting the back surface of the heat sink with one side of at least the single heat-generating element. When the cooling intermediate composite body is immersed in the coolant, the coolant directly absorbs heat on the heat sink surface. The heat sink locally and powerfully absorbs heat from the heat-generating element, which is thermally connected to the back surface of the heat sink. A bonding layer formed from a heterogeneous-material bonding film can provide a strong and stable watertight bond between the back surface of the heat sink and one surface of the bag. It is possible to ensure hermeticity of the entire cooling intermediate composite body, even if a window is formed in the heterogeneous-material bonding film or non-conductive bag. Conventional cooling methods based on immersion in a conductive coolant, such as water or seawater, have the problem that the coating or bag to keep the electronic apparatus watertight against the surrounding coolant hinders heat transfer between the heat-generating element and the coolant. Contrastingly, the cooling system according to the present invention utilizes the cooling intermediate composite body configured as above, thereby enabling the complete elimination of heat transfer issues between the heat-generating element and the coolant encountered in conventional methods, and improving the cooling performance of the electronic apparatus. Moreover, the cooling intermediate composite body as a whole can provide a strong and stable sealed structure even if a window is formed in the heterogeneous-material bonding film or non-conductive bag. When the inside of a non-conductive bag is vacuumized to seal it, the interior of the non-conductive bag comes into closely contact with both sides of the printed circuit board and the surfaces of the various electronic components mounted on the printed circuit board. It is possible to increase the efficiency of heat removal from various electronic components, thereby further improving the cooling performance of the electronic apparatus.

The non-conductive bag may be made of a synthetic resin (such as polyethylene, polypropylene, or polyester) that is water-resistant and relatively heat-resistant (for example, 100°C or more) and can maintain hermeticity (airtightness/watertightness) when sealed. The heterogeneous-material bonding film can form a bonding layer through rapid heat-press bonding and cooling fixation (alternatively, through the use of pressure, ultrasound, electromagnetic waves, or light irradiation, for example). The use of these can provide the cooling intermediate composite body simply, efficiently, and inexpensively. The electronic apparatus can be maintained simply by breaking the non-conductive bag of the cooling intermediate composite body and removing the electronic apparatus from the bag, ensuring excellent maintainability. Furthermore, it is possible to almost completely eliminate the risk of the electronic apparatus surface being contaminated by foreign matter. This is also advantageous from the viewpoint of reusing the used electronic apparatuses.

The above and other objects and advantages of the present invention will be more clearly understood through the following description of the embodiments. The embodiments described below are merely examples, and the present invention is not limited thereto.

### BRIEF DESCRIPTION OF THE DRAWINGS

Fig. 1A is a front view illustrating the configuration of main parts of a cooling system according to an embodiment of the present invention.
Fig. 1B is a side view illustrating the main parts of the cooling system according to an embodiment of the present invention.
Fig. 2 is an exploded view illustrating one example of a cooling intermediate composite body.
Fig. 3A is a diagram illustrating one example of the cooling intermediate composite body.
Fig. 3B is a diagram illustrating one example of the cooling intermediate composite body.
Fig. 4 is a cross-sectional view illustrating one example of the cooling intermediate composite body.
Fig. 5 is an explanatory diagram illustrating an example of placing an electronic apparatus in the cooling intermediate composite body.
Fig. 6 is a cross-sectional view illustrating an example of placing the electronic apparatus in the cooling intermediate composite body.
Fig. 7 is an exploded view illustrating another example of the cooling intermediate composite body.
Fig. 8A is a diagram illustrating another example of the cooling intermediate composite body.
Fig. 8B is a diagram illustrating another example of the cooling intermediate composite body.
Fig. 9 is a cross-sectional view illustrating another example of the cooling intermediate composite body.
Fig. 10 is an explanatory diagram illustrating another example of placing the electronic apparatus in the cooling intermediate composite body.
Fig. 11 is a cross-sectional view illustrating another example of placing the electronic apparatus in the cooling intermediate composite body.
Fig. 12 is a bottom view of a heat sink applied to still another example of the cooling intermediate composite body.
Fig. 13 is an explanatory diagram illustrating yet another example of placing the electronic apparatus in the cooling intermediate composite body.
Fig. 14 is a cross-sectional view illustrating yet another example of placing the electronic apparatus in the cooling intermediate composite body.
Fig. 15 is a cross-sectional view illustrating yet another example of placing the electronic apparatus in the cooling intermediate composite body.
Fig. 16 is a diagram illustrating the heat sink applied to still yet another example of the cooling intermediate composite body.
Fig. 17 is an exploded view illustrating yet still another example of the cooling intermediate composite body.
Fig. 18 is a cross-sectional view illustrating yet still another example of the cooling intermediate composite body.
Fig. 19 is an explanatory diagram illustrating yet another example of placing the electronic apparatus in the cooling intermediate composite body.
Fig. 20 is a cross-sectional view illustrating yet another example of placing the electronic apparatus in the cooling intermediate composite body.
Fig. 21 is a bottom view of the heat sink applied to still another example of the cooling intermediate composite body.
Fig. 22 is an explanatory diagram illustrating yet another example of placing the electronic apparatus in the cooling intermediate composite body.
Fig. 23 is a cross-sectional view illustrating yet another example of placing the electronic apparatus in the cooling intermediate composite body.
Fig. 24 is an exploded view illustrating yet still another example of the cooling intermediate composite body.
Fig. 25 is a cross-sectional view illustrating yet still another example of the cooling intermediate composite body.
Fig. 26 is a cross-sectional view illustrating yet another example of placing the electronic apparatus in the cooling intermediate composite body.
Fig. 27 is a cross-sectional view illustrating yet another example of placing the electronic apparatus in the cooling intermediate composite body.
Fig. 28 is a diagram illustrating an operation of the cooling system.

### DETAILED DESCRIPTION

The following describes preferred embodiments of the cooling system according to the present invention in detail by referencing the drawings.

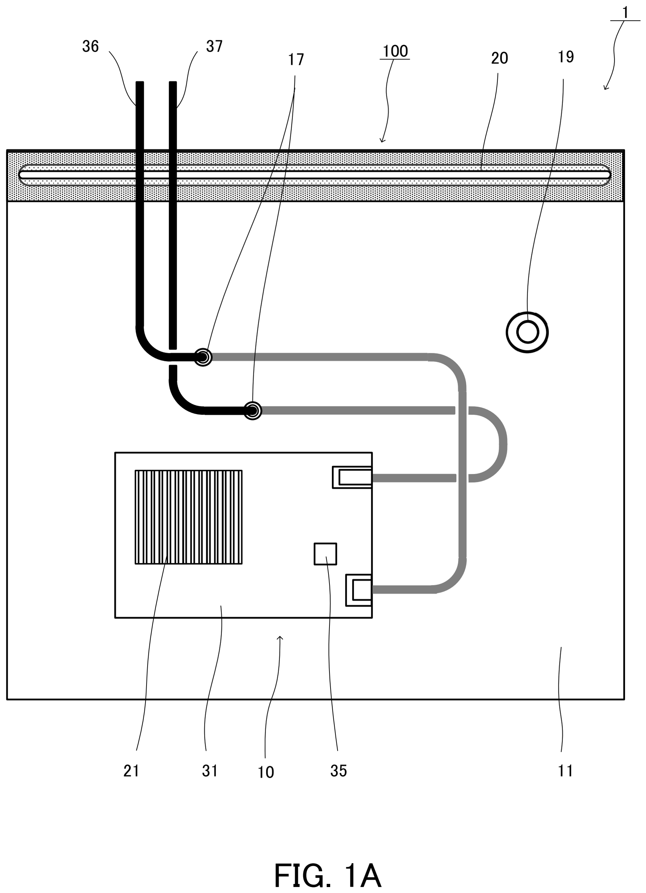

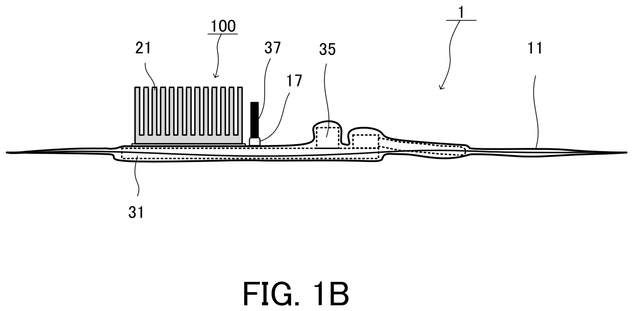

Referring to Figs. 1A and 1B, a cooling system 1 includes a cooling intermediate composite body 100. The cooling intermediate composite body 100 includes a non-conductive bag 11 for encasing the electronic apparatus 10, a heat sink 21, and a bonding layer 23 connecting the back surface of the heat sink 21 with one surface of the non-conductive bag 11 (to be described). The heat sink signifies a copper or aluminum heat radiator that can be thermally connected to a heat-generating element of the electronic apparatus. The heat sink may include multiple plate- or rod-shaped fins on its surface to increase its surface area.

The non-conductive bag 11 is made of a synthetic resin film (such as polyethylene, polypropylene, or polyester) that is water-resistant and relatively heat-resistant (100°C or more, for example) and can maintain hermeticity (airtightness/watertightness) when sealed. A zipper mechanism 20 is provided for one side of the non-conductive bag 11. The zipper mechanism 20, when opened, enables the electronic apparatus 10 to be placed in the non-conductive bag 11 and, when closed, maintains hermeticity of the non-conductive bag 11. Additionally, a check valve 19 is provided for one surface of the non-conductive bag 11. The check valve 19 provides a path for vacuumizing inside the non-conductive bag 11 and maintains hermeticity during and after the vacuumization.

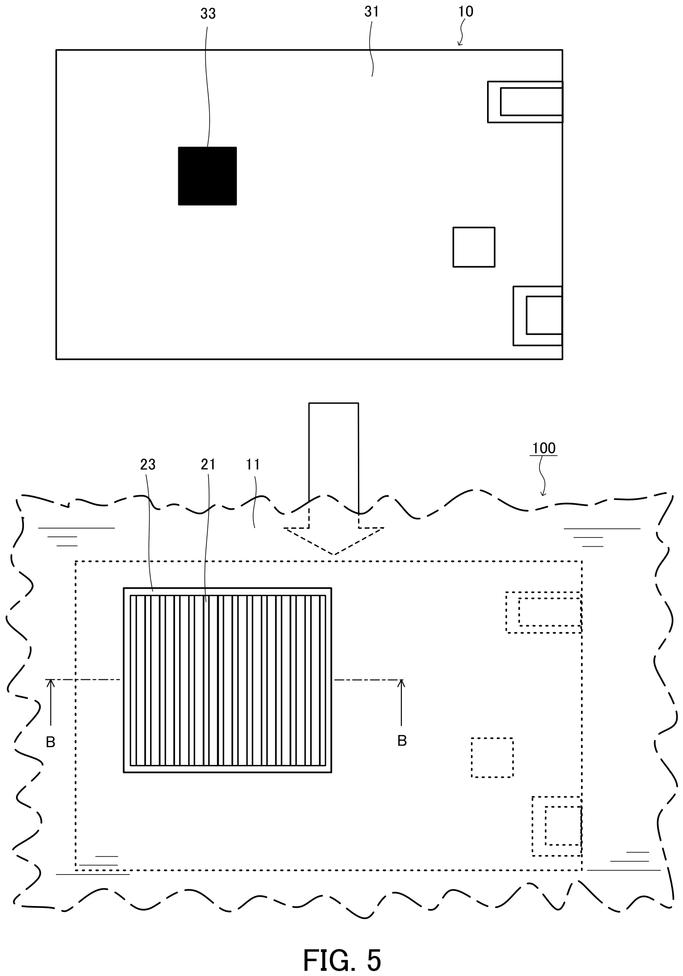

The electronic apparatus 10 includes a printed circuit board 31, at least one heat-generating element 33 (such as a CPU, as illustrated in Fig. 5 and elsewhere) mounted on the printed circuit board 31, and various electronic components 35, such as electrolytic capacitors. Each end of a network communication cable 36 and a power cable 37 is connected to the electronic apparatus 10 placed in the non-conductive bag 11 via connectors. The network communication cable 36 and the power cable 37 pass through penetration portions formed on one surface of the non-conductive bag 11. The penetration portion is provided with a sealing material 17. This makes it possible to connect the other ends of the network communication cable 36 and the power cable 37 to a network apparatus and a power distribution apparatus outside the non-conductive bag 11, while maintaining hermeticity of the non-conductive bag 11.

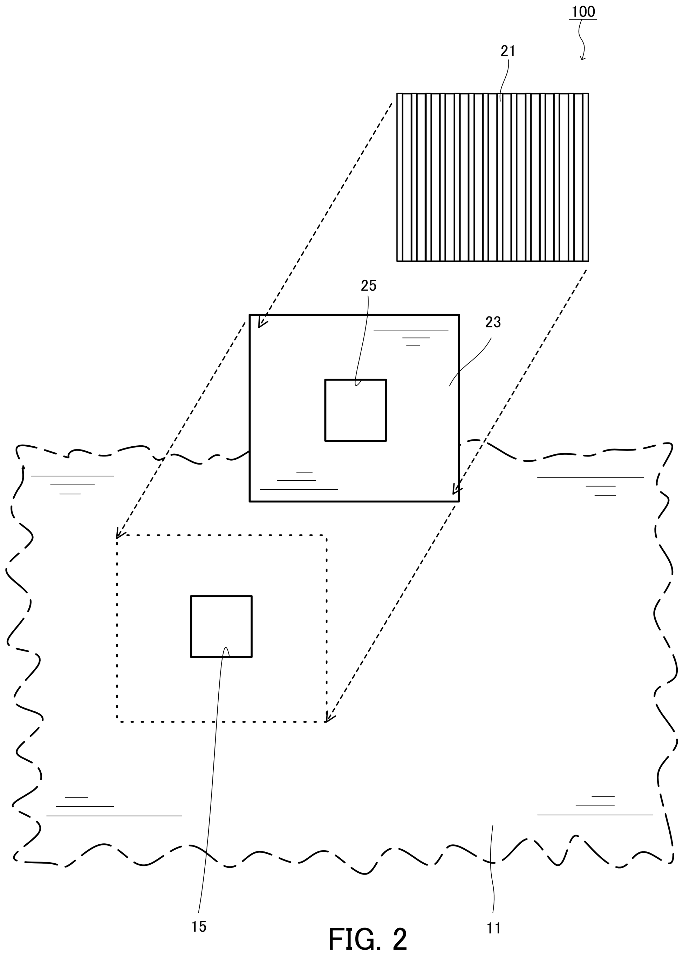

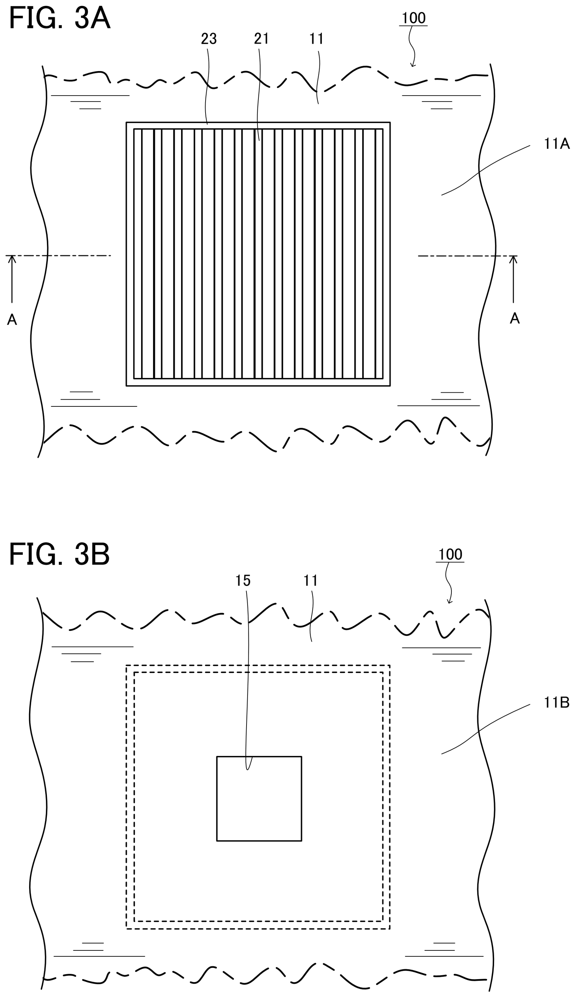

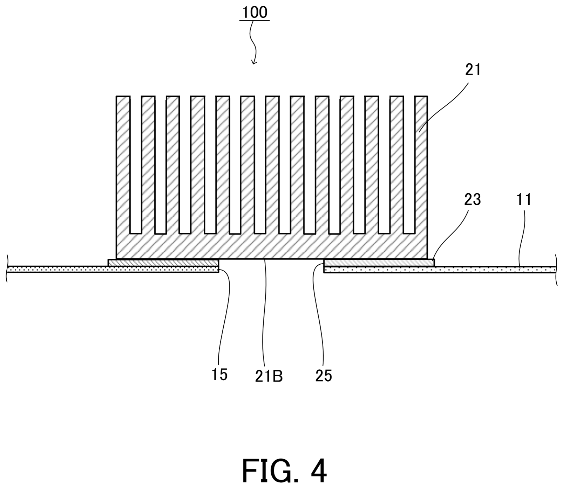

Fig. 2 is an exploded view of the cooling intermediate composite body 100, including its components, such as the non-conductive bag 11, the heat sink 21, and the bonding layer 23. Fig. 3A illustrates the cooling intermediate composite body 100 viewed from an exterior 11A of the non-conductive bag 11. Fig. 3B illustrates the cooling intermediate composite body 100 viewed from an interior 11B of the non-conductive bag 11. Fig. 4 is a cross-sectional view taken along the line A-A of Fig. 3A. The bonding layer 23 connects the back surface of the heat sink 21 with the exterior of the non-conductive bag 11. Particularly, the bonding layer 23 is formed of a heterogeneous-material bonding film. A first opening 25 is formed in the heterogeneous-material bonding film that forms the bonding layer 23. The first opening 25 provides a window for thermally connecting a back surface 21B of the heat sink 21 with one surface of the heat-generating element 33 (to be described). The size of the heterogeneous-material bonding film is favorably slightly larger than or equal to the size of the heat sink 21. The size of the first opening 25, comparable to the window, is favorably slightly larger than or equal to the size of the heat-generating element 33. A second opening 15 is favorably formed in the non-conductive bag 11. In this case, the size of the second opening 15 formed in the non-conductive bag 11 may be as large as the size of the first opening formed in the heterogeneous-material bonding film. The first opening 25 and the second opening 15 provide a common window to thermally connect the back surface of the heat sink 21 with one surface of the heat-generating element 33.

Examples of the heterogeneous-material bonding film to form the bonding layer 23 include the "Metaseal" series (a Fujimori Kogyo product name) manufactured by Fujimori Kogyo Co., Ltd. The uniformly thick heterogeneous-material bonding film is sandwiched between the back surface 21B of the heat sink 21 and the exterior 11A of the non-conductive bag 11. Then, heat and pressure are applied to the heterogeneous-material bonding film to form the bonding layer 23 that bonds the heat sink 21 and the non-conductive bag 11. A heat press or iron-type heater can be used for heat-press bonding to complete the bonding between the heat sink 21 and the non-conductive bag 11 easily and quickly (in a few seconds). The bonding layer 23 can be formed by not only heat-press bonding but also various methods, such as pressure, ultrasonic waves, electromagnetic waves, and light irradiation.

The bonding layer 23 formed of a heterogeneous-material bonding film, can provide a surface bond between the back surface 21B of the heat sink 21 and the exterior 11A of the non-conductive bag 11 while ensuring uniform adhesive strength and film thickness. The bonding layer 23 can be used for firm bonding between the heat sink and the bag.

It is also possible to use "WelQuick" (a Resonac Corporation product name), as another example of heterogeneous-material bonding films for forming the bonding layer 23. This heterogeneous-material bonding film utilizes a solid-liquid phase change of the film material, making it possible not only to complete a bonding process quickly (in a few seconds) but also to peel and re-bond the film by reheating after bonding. It is possible to facilitate a process of recovering the cooling intermediate composite body 100 from the cooling system after a predetermined period of use, and removing the heat sink 21 from the non-conductive bag 11. High resource reusability can be expected.

Favorably, the heterogeneous-material bonding film can be pre-formed in a sheet or film and then cut into proper sizes. Alternatively, it may be advantageous to start from a liquid or gel adhesive material and form a heterogeneous-material bonding film into the bonding layer 23 under a specified environment, if available, that can appropriately control various conditions, including film thicknesses and shapes, for example. Specifically as an example, at first, a mold is placed on the back surface of the heat sink (or the back surface of the heat sink and the interior of the non-conductive bag). The mold is then filled with a liquid or gel adhesive material. The coating film, having an intended shape (including a window at the center) and a specified volume of adhesive material, can be formed on the back surface of the heat sink (or the back surface of the heat sink and the interior of the non-conductive bag). Next, the method of heat-press bonding, pressure, ultrasonic waves, electromagnetic waves, or light irradiation, for example, can then harden the coating film made of the adhesive material, while in contact with the back surface of the heat sink and the exterior of the non-conductive bag (or the back surface of the heat sink and the interior of the non-conductive bag). Consequently, it is possible to provide the bonding layer formed of the heterogeneous-material bonding film, starting from a liquid or gel adhesive material.

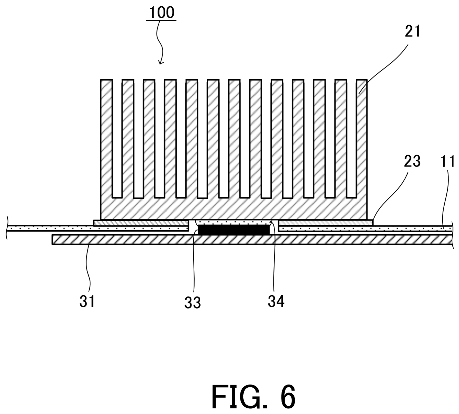

Fig. 5 illustrates an example of placing the electronic apparatus 10 in the cooling intermediate composite body 100. Fig. 6 is a cross-sectional view taken along the line B-B of Fig. 5. As illustrated in Fig. 5, the electronic apparatus 10 is placed in the cooling intermediate composite body 100. As illustrated in Fig. 6, one surface of the heat-generating element 33 makes surface contact with and thermally connects to the back surface 21B of the heat sink 21 through the windows formed in the non-conductive bag 11 and the heterogeneous-material bonding film 23. To ensure surface contact and thermal connection, it is advantageous to fill a slight gap between the one surface of the heat-generating element 33 and the back surface 11B of the heat sink 21, with thermal conductive grease 34. After the electronic apparatus 10 is placed in the cooling intermediate composite body 100, the zipper mechanism is used to close the non-conductive bag 11. The inside of the non-conductive bag 11 is then vacuumized via the check valve 19. The vacuumization can allow the interior of the non-conductive bag to be in closely contact with both sides of the printed circuit board and the surfaces of the various electronic components mounted on the printed circuit board.

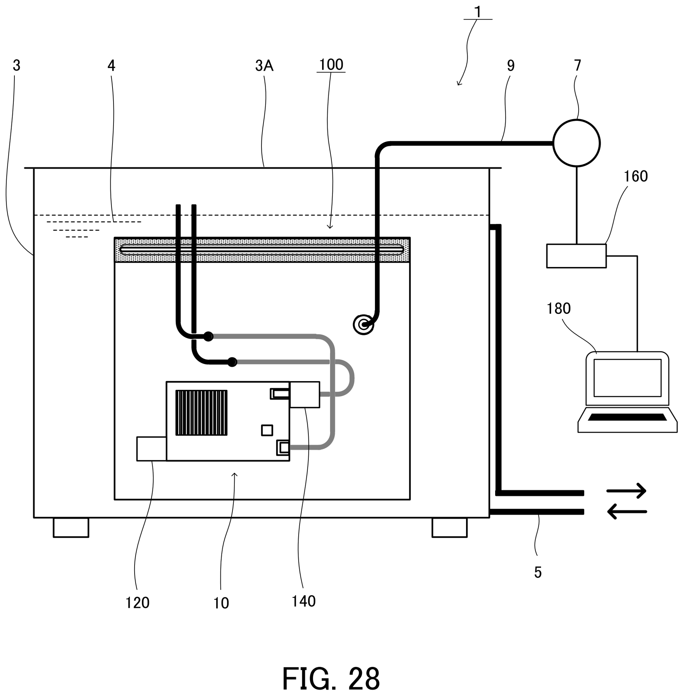

Fig. 28 illustrates the operation of the cooling system 1. The cooling tank 3 contains a sufficient amount of coolant 4 to immerse the cooling intermediate composite body 100. The coolant 4 can be ordinary water (such as tap water, industrial water, or seawater). Piping 5 connected to the cooling tank 3 provides a path that discharges the coolant heated in the cooling tank 3 and returns the coolant cooled by a heat exchanger (not shown) to the cooling tank 3. The coolant 4 directly absorbs heat from the surface of the heat sink 21 in the cooling intermediate composite body 100 immersed in the coolant 4. The heat sink 21 locally and powerfully absorbs heat from the heat-generating element 33 thermally connected to the back surface 21B of the heat sink 21. Conventional cooling methods have the problem that the coating or bag, which covers the electronic apparatus or the semiconductor device, hinders heat transfer between the heat-generating element and the coolant. Such a problem can be eliminated and the cooling performance of electronic apparatuses can be improved. The vacuumization of the non-conductive bag 11 can allow its interior to closely contact both sides of the printed circuit board 31 and the surfaces of the various electronic components 35 mounted on the printed circuit board 31. It is possible to increase the efficiency of heat removal from the various electronic components 35 and further improve the cooling performance of the electronic apparatus 100.

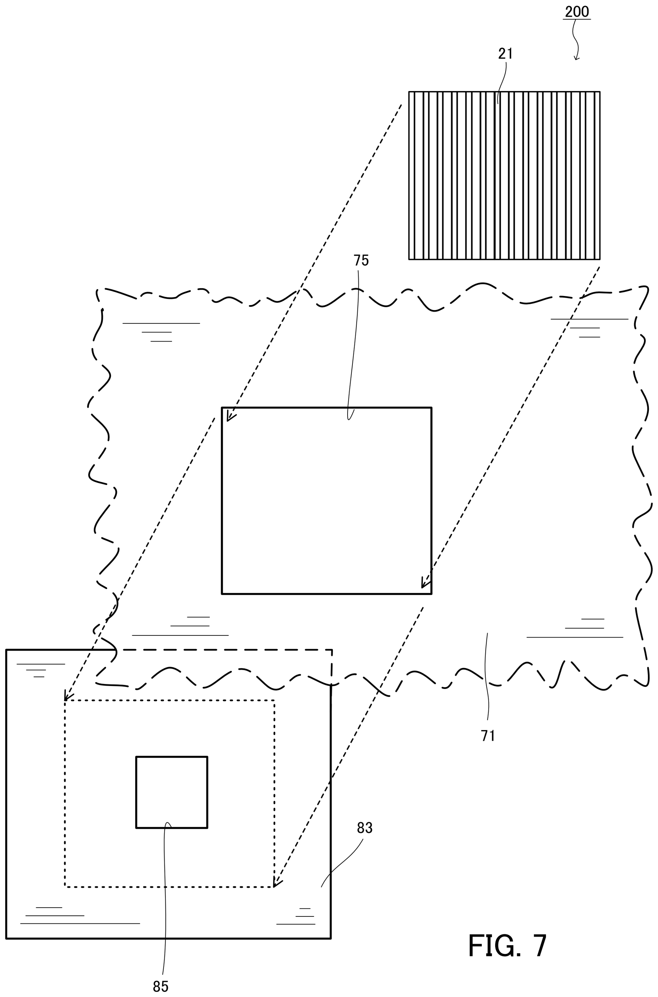

The following describes other examples of cooling intermediate composite bodies by referencing Figs. 7 through 27. The same reference numerals are used to represent the same parts as illustrated in Figs. 1A to 6.

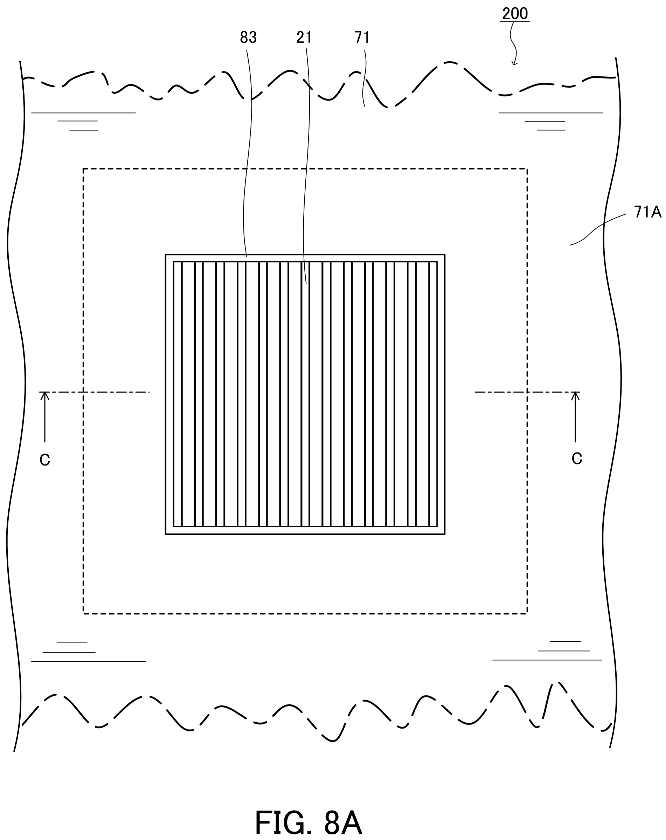

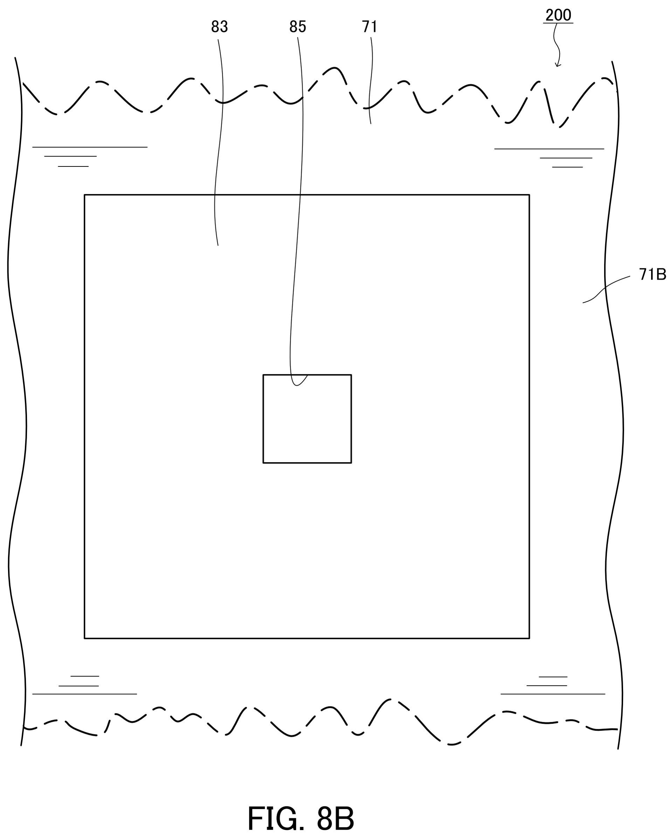

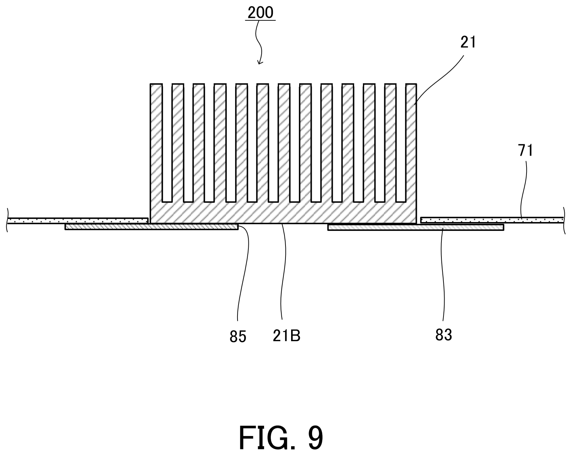

Fig. 7 is an exploded view of a cooling intermediate composite body 200, illustrating another example of a cooling intermediate composite body, which includes its components, such as a non-conductive bag 71, the heat sink 21, and a bonding layer 83. Fig. 8A illustrates the cooling intermediate composite body 200 viewed from an exterior 71A of the non-conductive bag 71. Fig. 8B illustrates the cooling intermediate composite body 200 viewed from an interior 71B of the non-conductive bag 71. Fig. 9 is a cross-sectional view taken along the line C-C of Fig. 8A. The bonding layer 83 connects the back surface of the heat sink 21 with the exterior of the non-conductive bag 11. The bonding layer 83 is formed of a heterogeneous-material bonding film. A first opening 85 is formed in the heterogeneous-material bonding film that forms the bonding layer 83. The first opening 85 provides a window for thermally connecting a back surface 21B of the heat sink 21 with one surface of the heat-generating element 33. The size of the heterogeneous-material bonding film needs to be larger than the size of the heat sink 21. On the other hand ,favorably, the size of the first opening 85 corresponding to the window is slightly larger than or equal to the heat-generating element 33. A third opening 75 is formed in the non-conductive bag 71. The size of the third opening 75 is favorably slightly larger than or equal to the size of the heat sink 21. The heterogeneous-material bonding film is placed and heat-pressed to serve as a bridge between the back surface 21B of the heat sink 21 and the interior 71A of the non-conductive bag 71, adjacent to each other. Thus, the bonding layer 83 can be formed to bridge and bond the heat sink 21 and the non-conductive bag 71.

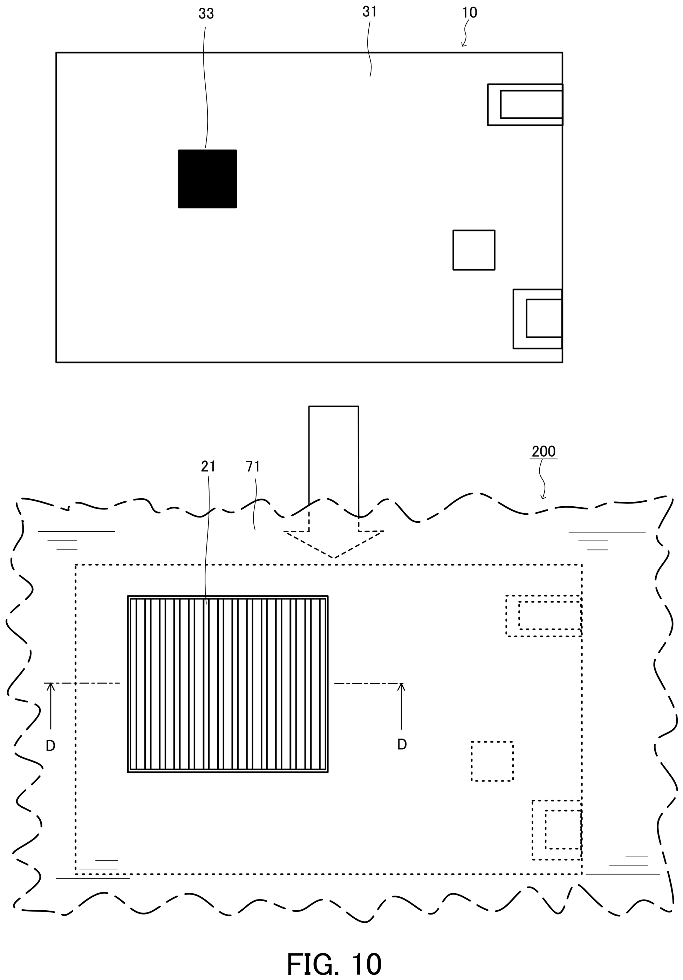

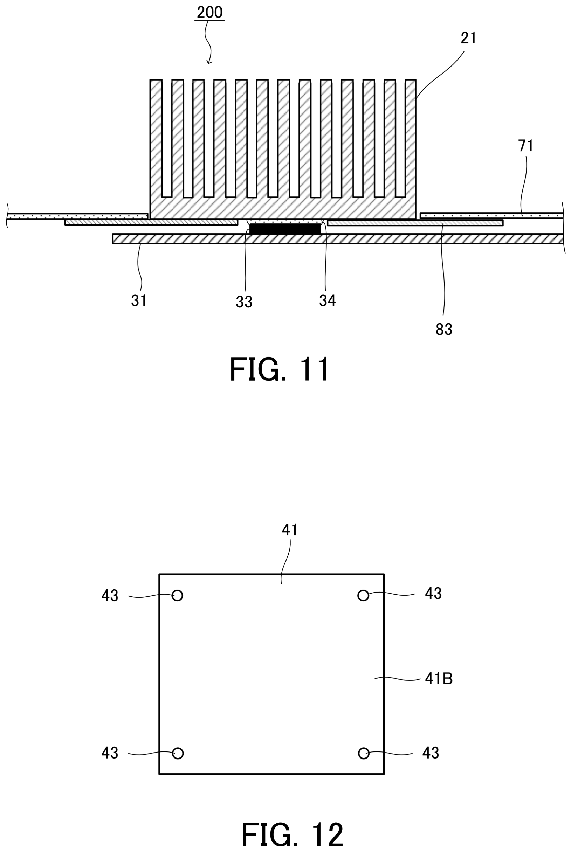

Fig. 10 illustrates an example of placing the electronic apparatus 10 in the cooling intermediate composite body 200. Fig. 11 is a cross-sectional view taken along the line D-D of Fig. 10. As illustrated in Fig. 10, the electronic apparatus 10 is placed in the cooling intermediate composite body 200. As illustrated in Fig. 11, one surface of the heat-generating element 33 makes surface contact with and thermally connects to the back surface 21B of the heat sink 21 through the windows formed in the heterogeneous-material bonding film 83. The cooling system, including the cooling intermediate composite body 200, according to the above-described configuration, provides the same effects as the cooling system including the cooling intermediate composite body 100 described above.

Figs. 12 through 14 illustrate still another example of the cooling intermediate composite body. A cooling intermediate composite body 300 differs from the cooling intermediate composite body 100, illustrated in Figs. 2 through 6, in that a heat sink 41 includes a PCB fixing mechanism 43. The PCB fixing mechanism 43 may provide two or more threaded holes, for example, mutually separately formed on the back surface 41B of the heat sink 41. According to the example illustrated in Fig. 12, threaded holes are formed at the four corners of the back surface 41B of the heat sink 41.

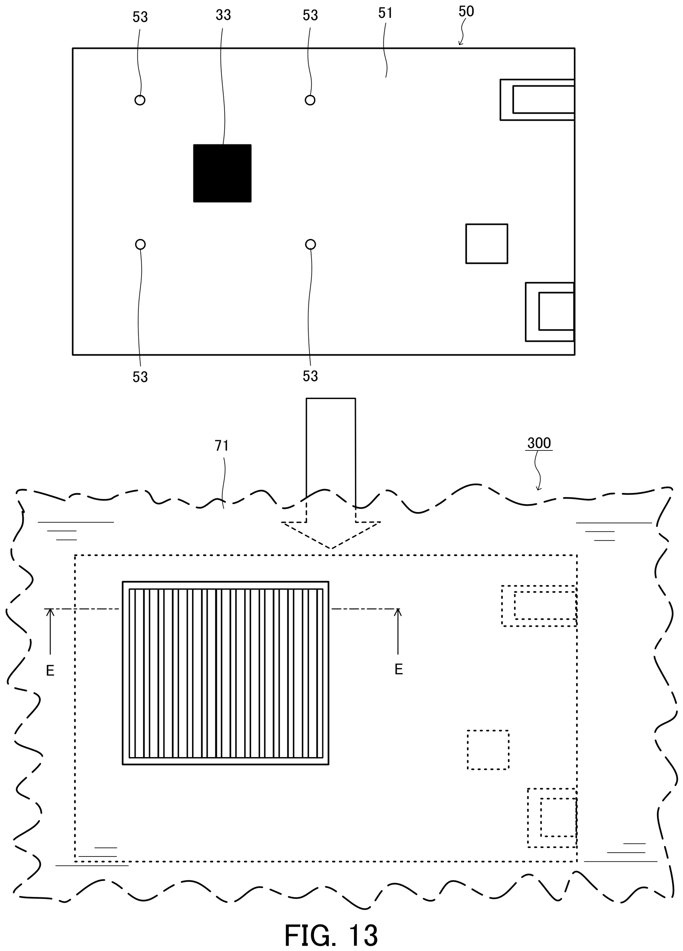

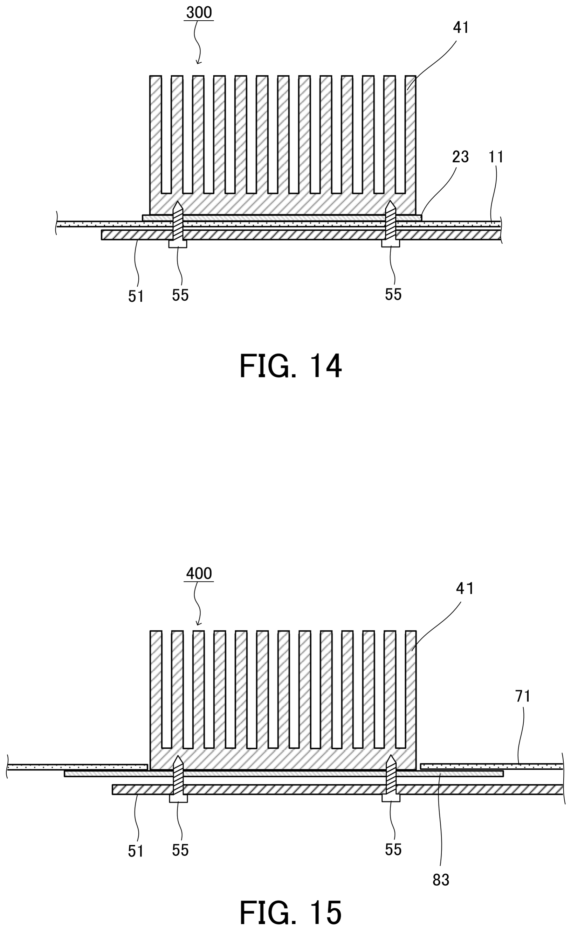

Fig. 13 illustrates an example of placing an electronic apparatus 50 in the cooling intermediate composite body 300. Fig. 14 is a cross-sectional view taken along the line E-E of Fig. 13. As illustrated in Fig. 13, the printed circuit board 51 of the electronic apparatus 50 also includes through holes 53 formed at positions corresponding to the threaded holes 43. To place the electronic apparatus 50 in the cooling intermediate composite body 300, screws 55 are inserted into the through holes 53 in the printed circuit board 51 to penetrate the non-conductive bag 11 and the bonding layer 23, and engage with the threaded holes 43 in the heat sink 41. The cooling system, including the cooling intermediate composite body 300 configured above, strongly binds the electronic apparatus 50 and the heat sink 41 of the cooling intermediate composite body 300. For example, this is particularly advantageous when large, heavy electronic apparatus is installed or when the surface to bind the electronic apparatus 50 and the heat sink 41 of the cooling intermediate composite body 300 is vertical or inclined rather than horizontal. The cooling system, including the cooling intermediate composite body 300, provides the same effects as the cooling system including cooling intermediate composite body 100 described above.

Fig. 15 illustrates yet another example of the cooling intermediate composite body. A cooling intermediate composite body 400 is configured similarly to the cooling intermediate composite body 200 illustrated in Figs. 7 through 11. The cooling intermediate composite body 400 differs from the cooling intermediate composite body 200 in that the heat sink 41 of the former includes the PCB fixing mechanism 43 illustrated in Fig. 12. The cooling system, including the cooling intermediate composite body 400, according to the above-described configuration, provides the same effects as the cooling system including the cooling intermediate composite body 300 described above.

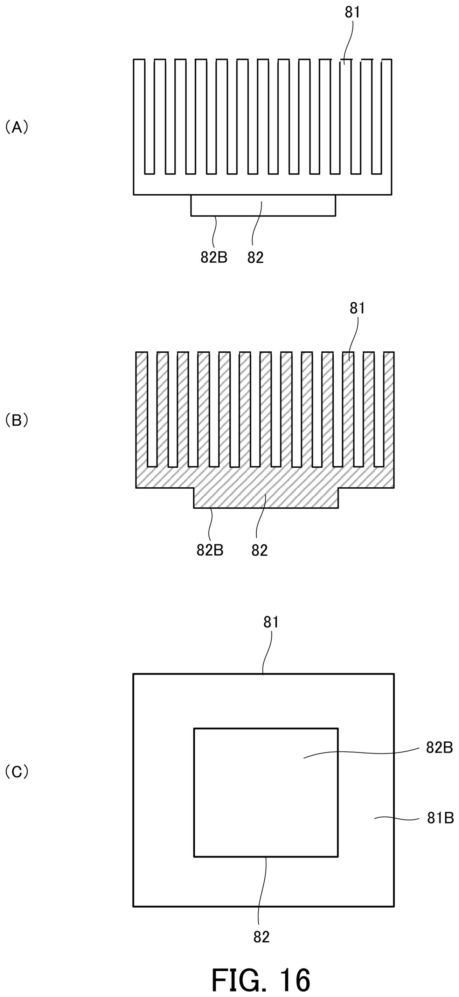

The following describes other examples of the cooling intermediate composite bodies by referencing Figs. 16 through 20. A cooling intermediate composite body 500 uses a heat sink 81 having the structure illustrated in Fig. 16. The heat sink 81 includes a rectangular elevated portion 82 formed near the center on its back surface 81B. The elevated portion 82 has a flat elevated surface 82B. In Fig. 16, (A) illustrates a front view of the heat sink 81, (B) a central cross-sectional view, and (C) a bottom view.

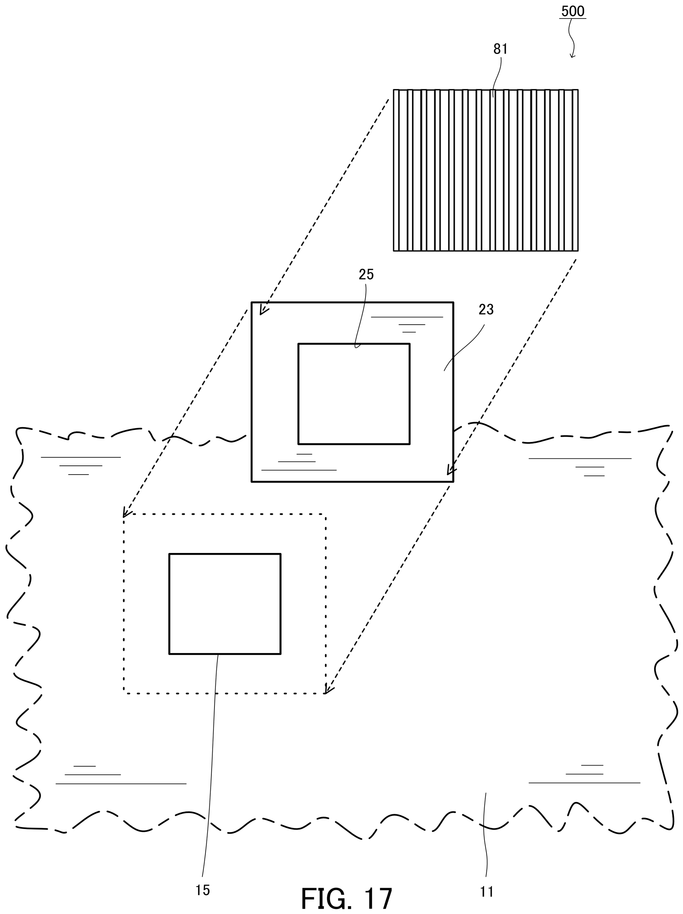

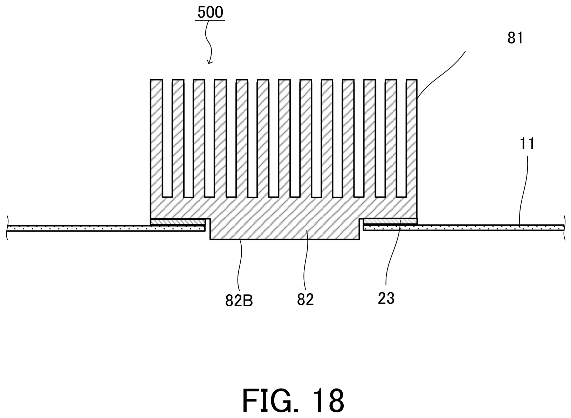

Fig. 17 is an exploded view of the cooling intermediate composite body 500, including its components, such as the non-conductive bag 11, the heat sink 81, and the bonding layer 23. Fig. 18 illustrates a central cross-sectional view of the cooling intermediate composite body 500. The bonding layer 23 connects the back surface 81B (excluding the elevated surface 82B) of the heat sink 81 with the exterior of the non-conductive bag 11. Particularly, the bonding layer 23 is formed of the heterogeneous-material bonding film. The first opening 25 is formed in the heterogeneous-material bonding film forming the bonding layer 23. As will be described later, the first opening 25 provides a window for thermally connecting the elevated surface 82B of the back surface of the heat sink 81 with one surface of a heat-generating element 63 of a large semiconductor device 32. The size of the heterogeneous-material bonding film is favorably slightly larger than or approximately equal to the size of the heat sink 81. The size of the first opening 25 corresponding to the window is favorably slightly larger than or approximately equal to the size of the elevated surface 82B of the elevated portion 82 on the back surface side of the heat sink 81. The second opening 15 is favorably formed in the non-conductive bag 11. In this case, the size of the second opening 15 formed in the non-conductive bag 11 may be approximately as large as the size of the first opening formed in the heterogeneous-material bonding film. The first opening 25 and the second opening 15 provide a common window to thermally connect the back surface of the heat sink 21 thermally connecting the elevated surface 82B on the back surface of the heat sink 21 with one surface of the heat-generating element 63.

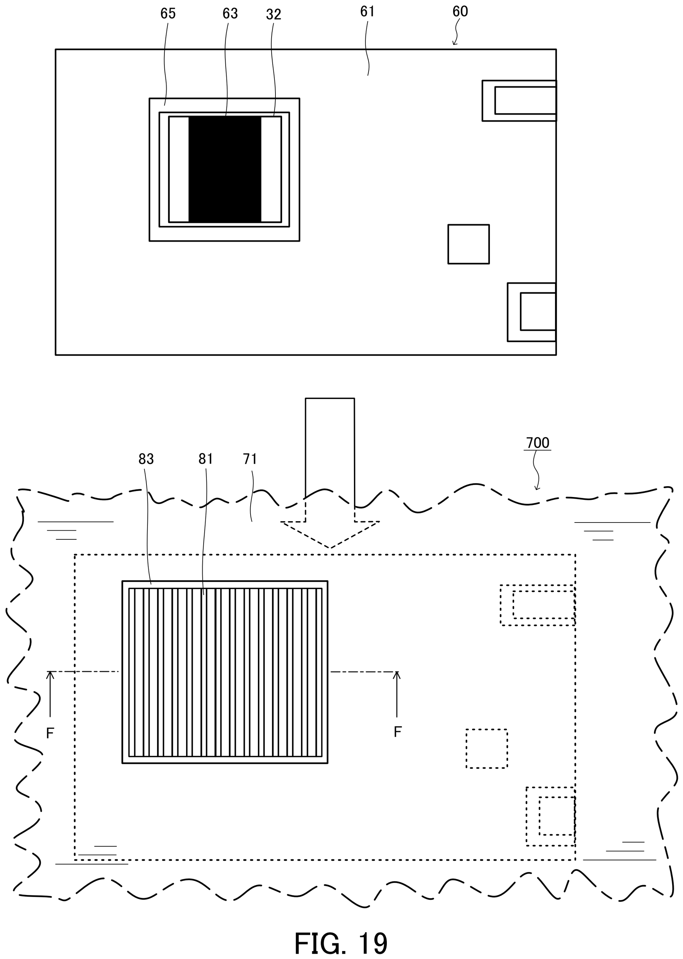

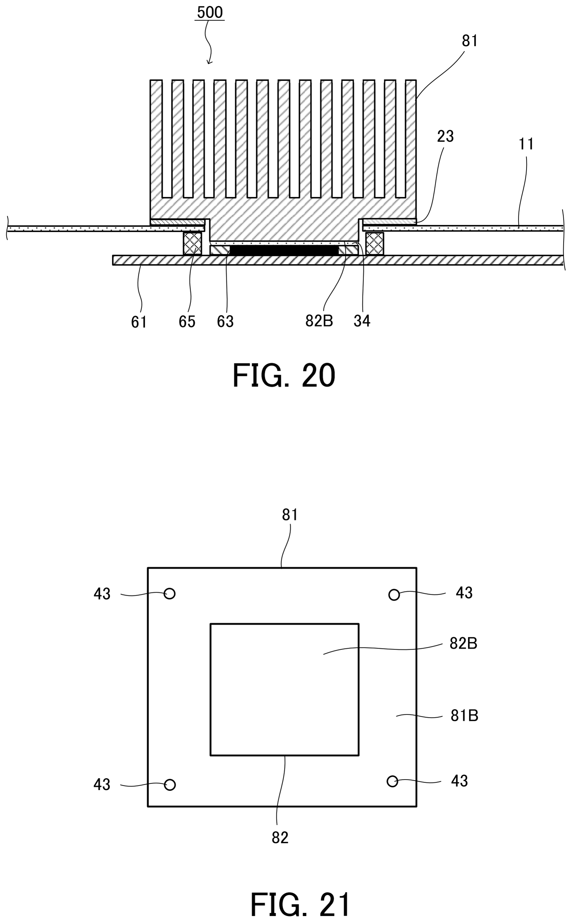

Fig. 19 illustrates an example of placing an electronic apparatus 60 in the cooling intermediate composite body 500. Fig. 20 is a cross-sectional view taken along the line F-F of Fig. 19. As illustrated in Fig. 19, the electronic apparatus 60 specifically includes the large semiconductor device 32 mounted on a printed circuit board 61. The large semiconductor device 32 includes a relatively large-area heat-generating element 63 near its center. A semiconductor frame 65 (sometimes called a stiffener) is provided to surround the rectangular edge of the large semiconductor device 32. The surface of the semiconductor frame 65, as a stiffener, may be higher than the surface of the large semiconductor device 32.

The electronic apparatus 60 is placed in the cooling intermediate composite body 500. As illustrated in Fig. 20, one surface of the heat-generating element 63 makes surface contact with and is thermally connected to the elevated surface 82B of the elevated portion 82 on the back surface side of the heat sink 81 through the windows formed in the non-conductive bag 11 and the heterogeneous-material bonding film 23. The elevated surface 82B is provided for the elevated portion 82 on the back surface of the heat sink 81. Therefore, the above-described connection is possible even if the surface of the large semiconductor device 32, namely, the surface of the heat-generating element 63, is lower than the surface of the semiconductor frame 65. To ensure surface contact and thermal connection, it is favorable to fill the slight gap between one surface of the heat-generating element 63 and the elevated surface 82B of the elevated portion 82 on the back surface side of the heat sink 81, with the thermal conductive grease 34.

Figs. 19 and 20 illustrate an example in which the large semiconductor device 32 includes a single heat-generating element 63. Moreover, the large semiconductor device 32 may include two or more heat-generating elements. In this case, the elevated surface 82B of one elevated portion 82 on the back surface of the heat sink 81 may make surface contact with and may be thermally connected to each of the two or more heat-generating elements.

Figs. 21 through 23 illustrate still another example of the cooling intermediate composite body. A cooling intermediate composite body 600 differs from the cooling intermediate composite body 500, illustrated in Figs. 16 through 20 in that the heat sink 81 includes the PCB fixing mechanism 43. The PCB fixing mechanism 43 may favorably provide two or more threaded holes that are mutually separately formed on the back surface 81B of the heat sink 81, excluding the elevated surface 82B. According to the example illustrated in Fig. 21, threaded holes are formed at the four corners of the back surface 81B of the heat sink 81.

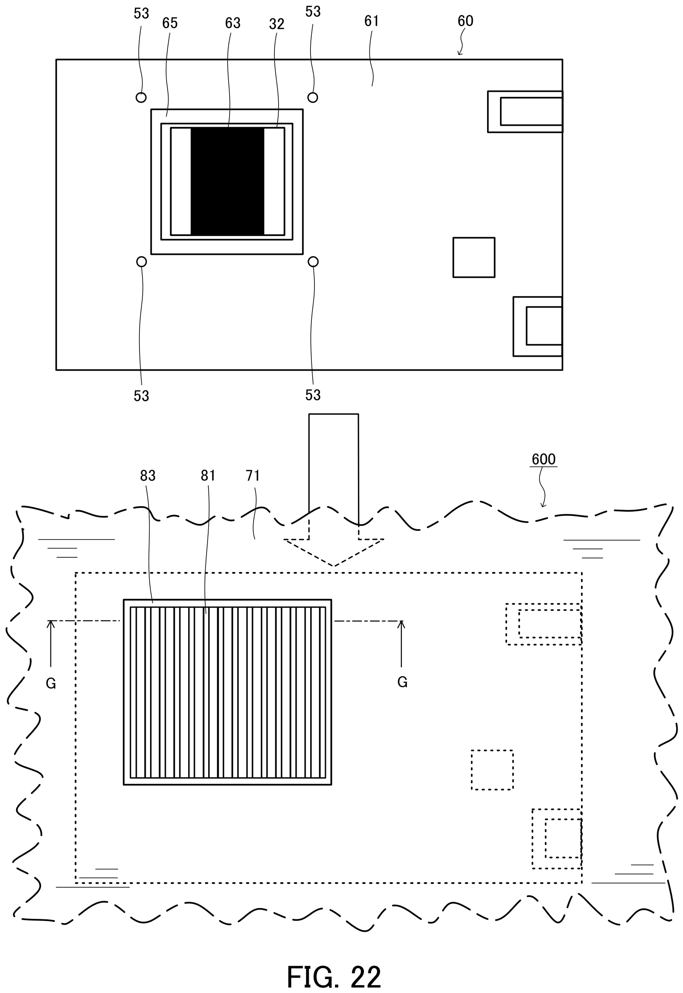

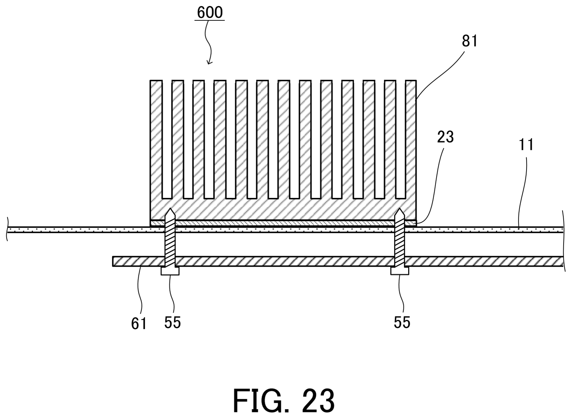

Fig. 22 illustrates an example of placing the electronic apparatus 60 in the cooling intermediate composite body 600. Fig. 23 is a cross-sectional view taken along the line G-G of Fig. 22. As illustrated in Fig. 22, the printed circuit board 61 of the electronic apparatus 60 also includes through holes 53 formed at positions corresponding to the threaded holes 43. To place the electronic apparatus 60 in the cooling intermediate composite body 600, the screws 55 are inserted into the through holes 53 in the printed circuit board 51 to penetrate the non-conductive bag 11 and the bonding layer 23, and engage with the threaded holes 43 in the heat sink 81. The cooling system, including the cooling intermediate composite body 600 configured above, strongly binds the electronic equipment 60 and the heat sink 81 of the cooling intermediate composite body 600. For example, this is particularly advantageous when large, heavy electronic equipment is installed or when the surface to bind the electronic equipment 50 and the heat sink 81 of the cooling intermediate composite body 600 is vertical or inclined rather than horizontal. The cooling system, including the cooling intermediate composite body 600, provides the same effects as the cooling system including cooling intermediate composite body 100 described above.

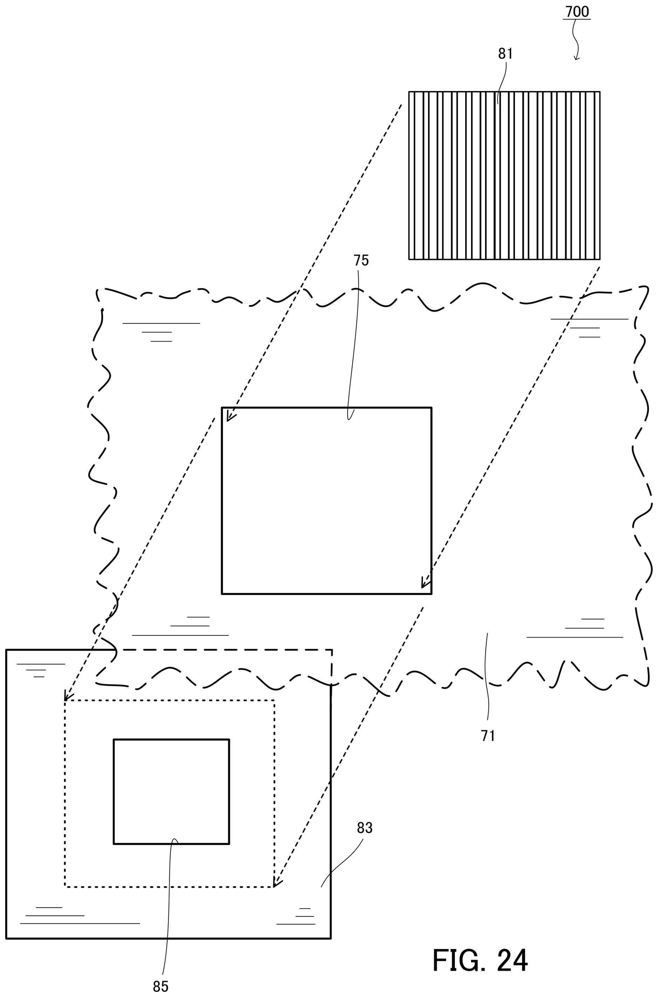

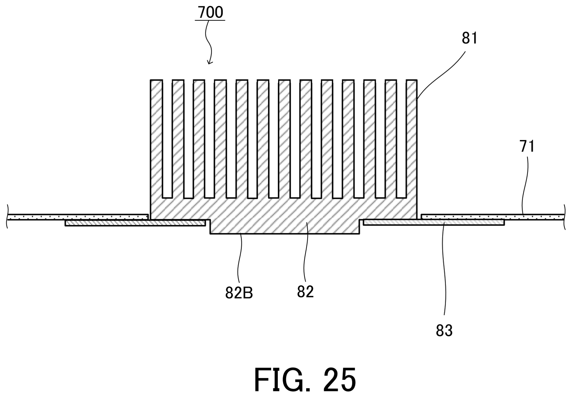

The following describes other examples of the cooling intermediate composite bodies by referencing Figs. 24 through 26. Fig. 24 is an exploded view of a cooling intermediate composite body 700, illustrating another example of a cooling intermediate composite body, which includes its components, such as the non-conductive bag 71, the heat sink 81, and the bonding layer 83. Fig. 25 illustrates a central cross-sectional view of the cooling intermediate composite body 700. The bonding layer 83 connects the back surface 81B (excluding the elevated surface 82B) of the heat sink 81 with the interior of the non-conductive bag 11. The bonding layer 83 is formed of the heterogeneous-material bonding film. The first opening 85 is formed in the heterogeneous-material bonding film, forming the bonding layer 83. The first opening 85 provides a window for thermally connecting the elevated surface 82B on the back surface of the heat sink 81 with one surface of the heat-generating element 33 of the large semiconductor device 32. The size of the heterogeneous-material bonding film needs to be larger than the size of the heat sink 81. Advantageously, the first opening 85, corresponding to the window, is slightly larger than or equal to the elevated surface 82B of the elevated portion 82 on the back surface of the heat sink 81. The size of the third opening 75 is formed in the non-conductive bag 71. Advantageously, the third opening 75 is slightly larger than or equal to the size of the heat sink 81. A heterogeneous-material bonding film is placed and heat-pressed to serve as a bridge between the back surface 81B (excluding the elevated surface 82B) of the heat sink 81 and the interior of the non-conductive bag 71, adjacent to each other. Thus, the bonding layer 83 can be formed to bridge and bond the heat sink 81 and the non-conductive bag 71.

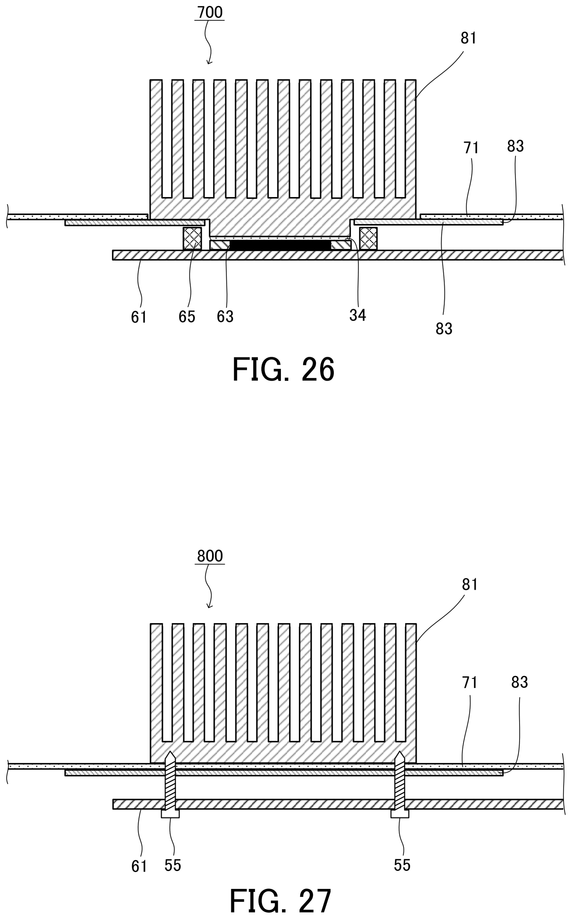

Fig. 26 illustrates a central cross-section of an example of placing the electronic apparatus 60 in the cooling intermediate composite body 700. When the electronic apparatus 60 is placed in the cooling intermediate composite body 700, one surface of the heat-generating element 63 of the large semiconductor device 32 makes surface contact with and is thermally connected to the elevated surface 82B on the back surface of the heat sink 81 through the window formed in the heterogeneous-material bonding film 83. The cooling system, including the cooling intermediate composite body 700, according to the above-described configuration, provides the same effects as the cooling system including the cooling intermediate composite body 500 described above.

Fig. 27 illustrates yet another example of the cooling intermediate composite body. A cooling intermediate composite body 800 is configured similarly to the cooling intermediate composite body 700 illustrated in Figs. 24 through 26. The cooling intermediate composite body 800 differs from the cooling intermediate composite body 700 in that the heat sink 81 of the former includes the PCB fixing mechanism 43 illustrated in Fig. 21. The cooling system, including the cooling intermediate composite body 800, according to the above-described configuration, provides the same effects as the cooling system including the cooling intermediate composite body 600 described above.

Referring again to Fig. 28, examples of the operation of the cooling system 1 will be described in more detail. Two or more cooling intermediate composite bodies 100 may be immersed in the coolant 4 contained in the cooling tank 3. A top plate 3A may be provided for the cooling tank 3 to reduce evaporation of the coolant 4. The cooling intermediate composite body 100 of the cooling system 1 may replace the power cable with a wireless power supply unit (not shown), which is included in the non-conductive bag 11, so that the electronic apparatus 10 is supplied with power. The network communication cable may be replaced with a wireless communication unit (not shown) to be included in the non-conductive bag 11 so that the electronic apparatus 100 can wirelessly communicate with the outside. In this case, there is no need for the penetration portion to pass cables, and the sealing material provided for the penetration portion. It is possible to eliminate the need for ensuring and maintaining the hermeticity of the penetration portion.

The cooling intermediate composite body 100 of the cooling system 1 may allow the non-conductive bag 11 to include a monitor unit 120 to monitor the vacuum level in the non-conductive bag 11. Furthermore, the cooling system 1 may include a controller 160. When the output from the monitor unit 120 indicates a vacuum level below a predetermined threshold, the controller 160 can provide control to activate an external vacuum pump 7 and vacuumize the non-conductive bag 11 via an air tube 9 connected to the check valve 19. Advantageously, an operator can visually check output values from the monitor unit 120 or operating states of the controller 160 on a computer (PC) 180 communicatively connected to the controller 160. The autonomous vacuumization is available as needed while the vacuum level is monitored. The cooling intermediate composite body 100 can maintain its near-vacuum sealed structure for a long time. Additionally, or alternatively, the cooling system 1 may include a shutdown unit 140. When the output from the monitor unit 120 indicates a vacuum level below a predetermined threshold, the shutdown unit 140 can stop operating the electronic apparatus 10 and turn off power. If the cooling intermediate composite body 100 loses the vacuum state, the surrounding coolant may enter the cooling intermediate composite body 100 to irreversibly damage the entire electronic apparatus 100. The shutdown unit 140 can prevent such a problem by instantly stopping the operation and power supply to the electronic apparatus 100.

The components of the cooling system according to the above-described embodiments can be modified variously. For example, the non-conductive bag may use a heat-sealing mechanism instead of the zipper mechanism. The heat-sealing mechanism may be configured so that an inactive heat-sealing state permits placement of the electronic apparatus in the non-conductive bag and vacuumization after heat sealing, while an active heat-sealing state maintains the hermeticity of the non-conductive bag. Two or more heat-generating elements may be mounted on the printed circuit board of the electronic apparatus. In such a case, considering the positions, sizes, and expected maximum heat generation of these heat-generating elements, it may be advantageous to determine, as needed, the size and/or number of heat sinks, the size and/or number of heterogeneous-material bonding films to form the bonding layer, the size and/or number of windows formed in the film, or the position, size, and/or number of windows formed in the non-conductive bag.

The present invention can be widely applied to cooling systems and methods that efficiently cool an electronic apparatus by immersing it in a conductive coolant, such as ordinary water, tap water, or seawater.

### REFERENCE SIGNS LIST

1 cooling system
3 cooling tank
3A top plate
4 coolant (water)
5 piping
7 vacuum pump
9 air tube
10, 50, 60 electronic apparatus
100, 200, 300, 400, 500, 600, 700, 800 cooling intermediate composite body
120 vacuum level monitor unit
140 shutdown unit
160 controller
180 computer (PC)
11, 71 non-conductive bag
11A, 71A exterior
11B, 71B interior
15, 85 window (second opening)
17 sealing material
19 check valve
20 zipper mechanism
21, 41, 81 heat sink
21B, 41B, 81B back surface of heat sink
82 elevated portion
81B back surface
82B flat elevated surface
23, 83, bonding layer
25, 85 window (first opening)
31, 51, 61 printed circuit board (PCB)

## Claims

1. A cooling system for cooling an electronic apparatus by immersing it in a coolant, comprising:
a cooling intermediate composite body,
wherein the cooling intermediate composite body includes;
a non-conductive bag for encasing an electronic apparatus that includes a printed circuit board and at least one heat-generating element mounted on the printed circuit board;
a heat sink; and
a bonding layer for making a watertight connection between a back surface of the heat sink and one surface of the non-conductive bag;
wherein the bonding layer is formed of a heterogeneous-material bonding film;
wherein a first opening is formed in the heterogeneous-material bonding film; and
wherein the first opening provides a window for thermally connecting the back surface of the heat sink with one surface of at least the single heat-generating element.

2. The cooling system according to claim 1,
wherein the bonding layer makes a watertight connection between the back surface of the heat sink and an exterior of the non-conductive bag.

3. The cooling system according to claim 2,
wherein a second opening is formed in the non-conductive bag; and
wherein the first opening and the second opening provide a window for thermally connecting the back surface of the heat sink with one surface of at least the single heat-generating element.

4. The cooling system according to claim 2,
wherein an elevated portion is formed on the back surface of the heat sink;
wherein a second opening is formed in the non-conductive bag; and
wherein the first opening and the second opening provide a window for thermally connecting an elevated surface of the elevated portion on the back surface of the heat sink with one surface of at least the single heat-generating element.

5. The cooling system according to claim 1,
wherein the non-conductive bag forms therein a third opening whose opening area is larger than a back surface area of the heat sink; and
wherein the bonding layer makes a watertight connection between the back surface of the heat sink placed in the third opening and an interior of the non-conductive bag.

6. The cooling system according to claim 1,
wherein an elevated portion is formed on the back surface of the heat sink;
wherein the non-conductive bag forms therein a third opening whose opening area is larger than an area of an elevated surface of the elevated portion on the back surface of the heat sink; and
wherein the bonding layer makes a watertight connection between a back surface, excluding the elevated surface, of the heat sink placed in the third opening and an interior of the non-conductive bag.

7. The cooling system according to claim 1,
wherein the heat sink includes a printed circuit board fixing mechanism; and
wherein the printed circuit board of the electronic apparatus is fastened to the printed circuit board fixing mechanism of the heat sink.

8. The cooling system according to claim 7,
wherein the printed circuit board fixing mechanism of the heat sink provides two or more threaded holes mutually separately formed on the back surface of the heat sink.

9. The cooling system according to claim 1,
wherein the cooling intermediate composite body is configured so that an interior of the non-conductive bag is in closely contact with both sides of the printed circuit board and a surfaces of various electronic components mounted on the printed circuit board when the non-conductive bag is vacuumized inside.

10. The cooling system according to claim 9,
wherein the non-conductive bag is configured to include a check valve that can provide a path for vacuumization and maintain hermeticity.

11. The cooling system according to claim 9,
wherein the non-conductive bag includes a zipper mechanism; and
wherein the zipper mechanism is configured so that an opened-zipper state permits placement of the electronic apparatus in the non-conductive bag, while a closed-zipper state maintains hermeticity of the non-conductive bag.

12. The cooling system according to claim 9,
wherein the non-conductive bag includes a heat-sealing mechanism; and
wherein the heat-sealing mechanism is configured so that an inactive heat-sealing state permits placement of the electronic apparatus in the non-conductive bag and vacuumization after heat sealing, while an active heat-sealing state maintains hermeticity of the non-conductive bag.

13. The cooling system according to claim 9,
wherein the non-conductive bag forms a through-hole for passing a power cable, a network communication cable, or a control cable connected to the electronic apparatus; and wherein a sealing material provided for the through-hole is configured to maintain hermeticity of the non-conductive bag.

14. The cooling system according to claim 9,
wherein the cooling intermediate composite body further includes, in the non-conductive bag, a wireless power supply unit for supplying power to the electronic apparatus and a wireless communication unit for enabling wireless communication between the electronic apparatus and the outside.

15. The cooling system according to claim 9,
wherein the cooling intermediate composite body further includes, in the non-conductive bag, a monitor unit for monitoring the degree of vacuum in the non-conductive bag.

16. The cooling system according to claim 15 further comprising:
an exhaust controller that provides control to activate a vacuum pump placed outside the cooling intermediate composite body and vacuumize the non-conductive bag inside when output from the monitor unit indicates a vacuum level below a predetermined threshold.

17. The cooling system according to claim 15 further comprising:
a shutdown unit that stops operation of the electronic apparatus and turns off power when output from the monitor unit indicates a vacuum level below a predetermined threshold.

18. A cooling method for electronic apparatuses comprising the steps of:
preparing a cooling intermediate composite body including: a non-conductive bag for encasing an electronic apparatus including a printed circuit board and at least one heat-generating element mounted on the printed circuit board; a heat sink; and a bonding layer to make a watertight connection between a back surface of the heat sink and one surface of the non-conductive bag, the bonding layer being formed of a heterogeneous-material bonding film;
placing the electronic apparatus in the cooling intermediate composite body and making surface contact with and thermally connecting one surface of at least one heat-generating element with the back surface of the heat sink through a window formed in the heterogeneous-material bonding film;
sealing the non-conductive bag; and
immersing the sealed cooling intermediate composite body in a refrigerant.

19. The method according to claim 18,
wherein the bonding layer makes a watertight connection between the back surface of the heat sink and an exterior of the non-conductive bag, or between the back surface of the heat sink and an interior of the non-conductive bag.

20. The method according to claim 18,
wherein the step of sealing the non-conductive bag includes a step of vacuumizing the non-conductive bag inside.
